# EUROPEAN PATENT APPLICATION

(11) **EP 4 216 431 A1**
(43) Date of publication of application: **26.07.2023**
(21) Application number: 21885178.0
(22) Date of filing: 26.10.2021
(51) Int. Cl.: H03F 3/04, H02M 1/14

(54) **PHASE COMPENSATION DEVICE AND METHOD**

(30) Priority: 30.10.2020 CN 202011189689
(71) Applicant: Huawei Technologies Co., Ltd., Shenzhen, Guangdong 518129 (CN)
(72) Inventor: CHENG, Qianfu, Shenzhen, Guangdong 518129 (CN); WANG, Guangjian, Shenzhen, Guangdong 518129 (CN); CAI, Hua, Shenzhen, Guangdong 518129 (CN)
(74) Representative: MERH-IP Matias Erny Reichl Hoffmann Patentanwälte PartG mbB
(86) International application number: PCT/CN2021/126521
(87) International publication number: WO 2022/089451

(57) **Abstract**

This application provides a phase compensation apparatus and method. The phase compensation apparatus can perform phase compensation on a baseband signal based on a digital ripple signal, to obtain a compensated baseband signal, and convert the compensated baseband signal into a radio frequency signal. The digital ripple signal is obtained based on a ripple signal of a high voltage for a cathode that supplies power to a cathode of a vacuum amplifier. The phase compensation apparatus in this application can implement phase compensation on a baseband, and convert the compensated baseband signal, to obtain the radio frequency signal. This avoids use of a low-precision phase shifter and a complex bias compensation circuit, reduces complexity of a circuit design, and improves phase compensation precision.

## Description

This application claims priority to Chinese Patent Application No. 202011189689.9, filed with the China National Intellectual Property Administration on October 30, 2020 and entitled "PHASE COMPENSATION APPARATUS AND METHOD", which is incorporated herein by reference in its entirety.

### TECHNICAL FIELD

This application relates to the field of communication technologies, and in particular, to a phase compensation apparatus and method.

### BACKGROUND

With an increasing requirement for a transmission capacity, an operating frequency band of a communication system is being expanded. In an existing standard, an operating frequency band of a 5th generation (5th generation, 5G) system has been expanded to a millimeter wave frequency band. In a large-capacity millimeter wave communication system, a millimeter wave power amplifier is an indispensable module in a millimeter wave transmitter, and performance of the millimeter wave power amplifier directly determines performance of the millimeter wave transmitter.

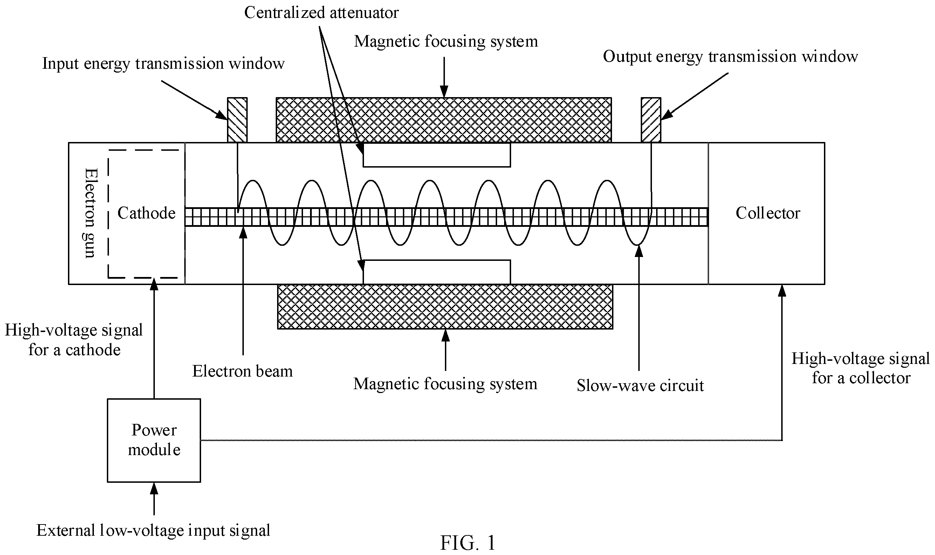

Currently, a commonly used millimeter wave power amplifier is a travelling wave tube amplifier (travelling wave tube amplifier, TWTA). As shown in FIG. 1, a complete TWTA includes a travelling wave tube (travelling wave tube, TWT) and a power module that supplies a high voltage to the TWT. The TWT mainly includes parts such as an electron gun, a slow-wave circuit, a centralized attenuator, an input energy transmission window, an output energy transmission window, a magnetic focusing system, and a collector. A function of the electron gun is to form an electron beam that meets a design requirement, and the electron gun mainly includes a cathode that can emit electrons inside. The magnetic focusing system keeps the electron beam in a desired shape, and ensures that the electron beam smoothly passes through the slow-wave circuit and interacts with an electric field effectively. Finally, the collector receives the electron beam. A to-be-amplified microwave signal enters the slow-wave circuit through the input energy transmission window, and travels along the slow-wave circuit. The electron beam exchanges energy with the travelling microwave signal, to amplify the microwave signal. An amplified microwave signal is output to a load through the output energy transmission window.

In an actual application, due to a limitation of a system volume, a high-voltage signal output by the power module usually has ripples. The high-voltage signal with the ripples is directly used to supply power to the cathode, and consequently, the electron beam emitted by the cathode carries modulation information of a ripple signal on an electron beam speed. After a modulated electron beam and an input microwave signal interact with each other, the modulation information is coupled into the input microwave signal in a form of phase noise, amplified together with the input microwave signal, and output to the load through the output energy transmission window.

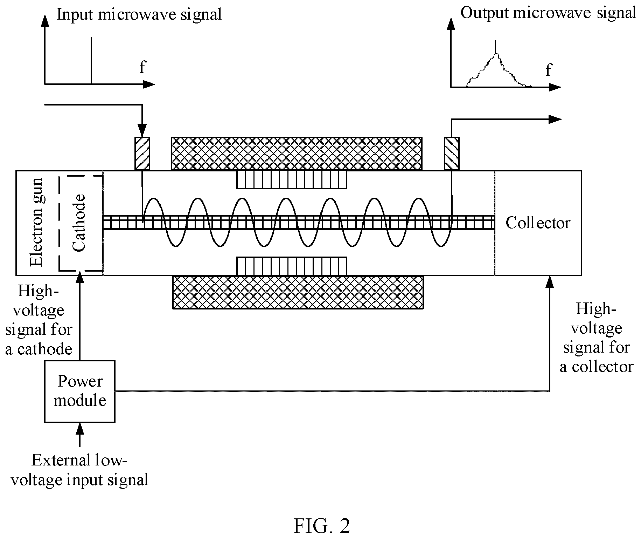

In conclusion, as shown in FIG. 2, because the output microwave signal carries a phase noise signal caused by the ripple signal, a spectrum of the output microwave signal is broadened, and a signal-to-noise ratio of the microwave signal is greatly reduced.

### SUMMARY

This application provides a phase compensation apparatus and method, to implement phase compensation on a baseband. This avoids use of a low-precision phase shifter and a complex bias compensation circuit, reduces complexity of a circuit design, and improves phase compensation precision.

To achieve the foregoing objective, this application uses the following technical solutions.

According to a first aspect, a phase compensation apparatus is provided. The phase compensation apparatus includes a processing module and a first conversion module. The processing module is configured to perform phase compensation on a first baseband signal based on a first digital ripple signal, to obtain a compensated first baseband signal, the first digital ripple signal is obtained based on a ripple signal of a first high voltage for a cathode, and the first high voltage for a cathode is used to supply power to a cathode of a first vacuum amplifier. The first conversion module is configured to convert the compensated first baseband signal into a first radio frequency signal.

Based on the phase compensation apparatus, the processing module can perform phase compensation on the first baseband signal on a baseband based on a digital ripple signal (namely, the first digital ripple signal) corresponding to the first high voltage for a cathode, the first conversion module converts the compensated first baseband signal into the first radio frequency signal, and the first radio frequency signal may be amplified by a vacuum amplifier and then output to a load. This avoids use of a low-precision phase shifter and a complex bias compensation circuit on a radio frequency band, reduces complexity of a circuit design, and improves phase compensation precision based on high flexibility of baseband processing.

In some possible designs, the phase compensation apparatus further includes a phase detector and a first analog-to-digital conversion module. The processing module is further configured to determine a first phase compensation rule based on a first digital phase noise signal and a second digital ripple signal, and the first phase compensation rule is used for phase compensation for the first baseband signal. The first digital phase noise signal is a signal obtained after a first output signal of the phase detector is output to the processing module by using the first analog-to-digital conversion module, a first input signal of the phase detector is an original input signal of the first vacuum amplifier, and a second input signal is an original output signal of the first vacuum amplifier. The second digital ripple signal is obtained based on a ripple signal of a second high voltage for a cathode, and the second high voltage for a cathode is used to supply power to the cathode of the first vacuum amplifier before the first high voltage for a cathode.

In some possible designs, that the processing module is configured to perform phase compensation on a first baseband signal based on a first digital ripple signal, to obtain a compensated first baseband signal includes: The processing module is configured to determine a first phase compensation signal based on the first digital ripple signal and the first phase compensation rule; and the processing module is further configured to perform phase compensation on the first baseband signal based on the first phase compensation signal, to obtain the compensated first baseband signal.

Based on the two possible designs, before performing phase compensation, the phase compensation apparatus may first determine a phase compensation rule, and then perform phase compensation based on the phase compensation rule. In addition, when determining the phase compensation rule, impact of a characteristic of the vacuum amplifier on a power supply ripple signal is considered, so that a phase compensation signal determined based on the phase compensation rule is more accurate, to further improve phase compensation precision.

In some possible designs, the first phase compensation rule is a first model. That the processing module is further configured to determine a first phase compensation rule based on a first digital phase noise signal and a second digital ripple signal includes: The processing module is configured to establish the first model by using the second digital ripple signal as a model input and the first digital phase signal noise as a model output. That the processing module is configured to determine a first phase compensation signal based on the first digital ripple signal and the first phase compensation rule includes: The processing module is configured to input the first digital ripple signal into the first model, to obtain the first phase compensation signal.

Based on this possible design, when the first phase compensation rule is the first model, the first phase compensation signal can be obtained by inputting the first digital ripple signal into the first model. This can reduce complexity of determining a phase compensation signal. In addition, the model can be flexibly adjusted in real time, to improve real-time performance and flexibility of phase compensation.

In some possible designs, the phase compensation apparatus further includes a second conversion module. The processing module is further configured to perform phase compensation on a second baseband signal based on the first digital ripple signal, to obtain a compensated second baseband signal. The second conversion module is configured to convert the compensated second baseband signal into a second radio frequency signal.

Based on the phase compensation apparatus, a same processing module can be used to perform phase compensation on a plurality of baseband signals used in a plurality of vacuum amplifiers, and a phase compensation circuit does not need to be separately designed for each vacuum amplifier, so that adaptability and practicability are high.

In some possible designs, the first high voltage for a cathode is further configured to supply power to a cathode of a second vacuum amplifier; the first conversion module is further configured to output the first radio frequency signal to the first vacuum amplifier; and the second conversion module is further configured to output the second radio frequency signal to the second vacuum amplifier. Alternatively, the first vacuum amplifier includes a first input energy transmission window and a second input energy transmission window; the first conversion module is further configured to output the first radio frequency signal to the first input energy transmission window of the first vacuum amplifier; and the second conversion module is further configured to output the second radio frequency signal to the second input energy transmission window of the first vacuum amplifier.

In some possible designs, the processing module is further configured to determine a second phase compensation rule based on a second digital phase noise signal and the second digital ripple signal, and the second phase compensation rule is used for phase compensation for the second baseband signal. The second digital phase noise signal is a signal obtained after a second output signal of the phase detector is output to the processing module by using the first analog-to-digital conversion module. When the first high voltage for a cathode is further used to supply power to the cathode of the second vacuum amplifier, the second high voltage for a cathode is further used to supply the power to the cathode of the second vacuum amplifier before the first high voltage for a cathode, a third input signal of the phase detector is an original input signal of the second vacuum amplifier, and a fourth input signal is an original output signal of the second vacuum amplifier. When the first vacuum amplifier includes the second input energy transmission window, a third input signal of the phase detector is an original input signal of the second input energy transmission window of the first vacuum amplifier, and a fourth input signal is an original output signal of a second output energy transmission window corresponding to the second input energy transmission window.

In some possible designs, that the processing module is configured to perform phase compensation on a second baseband signal based on the first digital ripple signal, to obtain a compensated second baseband signal includes: The processing module is configured to determine a second phase compensation signal based on the first digital ripple signal and the second phase compensation rule; and the processing module is further configured to perform phase compensation on the second baseband signal based on the second phase compensation signal, to obtain the compensated second baseband signal.

In some possible designs, the second phase compensation rule is a second model. That the processing module is further configured to determine a second phase compensation rule based on a second digital phase noise signal and the second digital ripple signal includes: The processing module is configured to establish the second model by using the second digital ripple signal as a model input and the second digital phase signal noise as a model output. That the processing module is configured to determine a second phase compensation signal based on the first digital ripple signal and the second phase compensation rule includes: The processing module is configured to input the first digital ripple signal into the second model, to obtain the second phase compensation signal.

In some possible designs, the phase compensation apparatus further includes a ripple signal preprocessing module and a second analog-to-digital conversion module. The ripple signal preprocessing module is configured to perform preprocessing on the ripple signal of the first high voltage for a cathode, to obtain a first analog ripple signal, and the preprocessing is used to adapt to an operating range of the second analog-to-digital conversion module. The second analog-to-digital conversion module is configured to perform analog-to-digital conversion on the first analog ripple signal, to obtain the first digital ripple signal.

Based on the possible design, the ripple signal preprocessing module performs preprocessing on the ripple signal of the first high voltage for a cathode, so that the first analog ripple signal output by the ripple signal preprocessing module adapts to the operating range of the second analog-to-digital conversion module, to improve precision of quantizing the ripple signal of the first high voltage for a cathode into the first digital ripple signal.

In some possible designs, the phase detector includes a frequency mixer, a 90-degree phase shifter, and a low-pass filter. Further, the phase detector may include an amplifier.

In some possible designs, the first high voltage for a cathode is supplied by a first power module, and the first power module is a low-voltage to high-voltage power module.

According to a second aspect, a phase compensation method is provided. The method includes: performing phase compensation on a first baseband signal based on a first digital ripple signal, to obtain a compensated first baseband signal, where the first digital ripple signal is obtained based on a ripple signal of a first high voltage for a cathode, and the first high voltage for a cathode is used to supply power to a cathode of a first vacuum amplifier; and converting the compensated first baseband signal into a first radio frequency signal. For technical effect brought by the second aspect, refer to technical effect brought by the first aspect, and details are not described herein again.

In some possible designs, the phase compensation method further includes: determining a first phase compensation rule based on a first digital phase noise signal and a second digital ripple signal, where the first phase compensation rule is used for phase compensation for the first baseband signal. The first digital phase noise signal is obtained based on a first output signal of a phase detector, a first input signal of the phase detector is an original input signal of the first vacuum amplifier, and a second input signal is an original output signal of the first vacuum amplifier. The second digital ripple signal is obtained based on a ripple signal of a second high voltage for a cathode, and the second high voltage for a cathode is used to supply power to the cathode of the first vacuum amplifier before the first high voltage for a cathode.

In some possible designs, the performing phase compensation on a first baseband signal based on a first digital ripple signal, to obtain a compensated first baseband signal includes: determining a first phase compensation signal based on the first digital ripple signal and the first phase compensation rule; and performing phase compensation on the first baseband signal based on the first phase compensation signal, to obtain the compensated first baseband signal.

In some possible designs, the first phase compensation rule is a first model. The determining a first phase compensation rule based on a first digital phase noise signal and a second digital ripple signal includes: establishing the first model by using the second digital ripple signal as a model input and the first digital phase signal noise as a model output; and the determining a first phase compensation signal based on the first digital ripple signal and the first phase compensation rule includes: inputting the first digital ripple signal into the first model, to obtain the first phase compensation signal.

In some possible designs, the phase compensation method may further include: performing phase compensation on a second baseband signal based on the first digital ripple signal, to obtain a compensated second baseband signal; and converting the compensated second baseband signal into a second radio frequency signal.

In some possible designs, when the first high voltage for a cathode is further used to supply power to a cathode of a second vacuum amplifier, the phase compensation method further includes: outputting the first radio frequency signal to the first vacuum amplifier, and outputting the second radio frequency signal to the second vacuum amplifier. Alternatively, when the first vacuum amplifier includes a first input energy transmission window and a second input energy transmission window, the phase compensation method further includes: outputting the first radio frequency signal to the first input energy transmission window of the first vacuum amplifier, and outputting the second radio frequency signal to the second input energy transmission window of the first vacuum amplifier.

In some possible designs, the phase compensation method further includes: determining a second phase compensation rule based on a second digital phase noise signal and the second digital ripple signal, where the second phase compensation rule is used for phase compensation for the second baseband signal. The second digital phase noise signal is obtained based on a second output signal of the phase detector. When the first high voltage for a cathode is further used to supply the power to the cathode of the second vacuum amplifier, the second high voltage for a cathode is further used to supply power to the cathode of the second vacuum amplifier before the first high voltage for a cathode, a third input signal of the phase detector is an original input signal of the second vacuum amplifier, and a fourth input signal is an original output signal of the second vacuum amplifier. When the first vacuum amplifier includes the second input energy transmission window, a third input signal of the phase detector is an original input signal of the second input energy transmission window of the first vacuum amplifier, and a fourth input signal is an original output signal of a second output energy transmission window corresponding to the second input energy transmission window.

In some possible designs, the performing phase compensation on a second baseband signal based on the first digital ripple signal, to obtain a compensated second baseband signal includes: determining a second phase compensation signal based on the first digital ripple signal and the second phase compensation rule; and performing phase compensation on the second baseband signal based on the second phase compensation signal, to obtain the compensated second baseband signal.

In some possible designs, the second phase compensation rule is a second model. The determining a second phase compensation rule based on a second digital phase noise signal and the second digital ripple signal includes: establishing the second model by using the second digital ripple signal as a model input and the second digital phase signal noise as a model output; and the determining a second phase compensation signal based on the first digital ripple signal and the second phase compensation rule includes: inputting the first digital ripple signal into the second model, to obtain the second phase compensation signal.

In some possible designs, that the first digital ripple signal is obtained based on a ripple signal of a first high voltage for a cathode includes: The first digital ripple signal is a digital ripple signal obtained after analog-to-digital conversion is performed on a first analog ripple signal, the first analog ripple signal is obtained after preprocessing is performed on the ripple signal of the first high voltage for a cathode, and the preprocessing is used to adapt to an operating range of an analog-to-digital conversion module.

For technical effect brought by any possible design of the second aspect, refer to technical effect brought by corresponding designs of the first aspect. Details are not described herein again.

### BRIEF DESCRIPTION OF DRAWINGS

FIG. 1 is a schematic diagram of a structure of a travelling wave tube amplifier according to an embodiment of this application;
FIG. 2 is a schematic diagram of spectrums of an input microwave signal and an output microwave signal of a travelling wave tube amplifier according to an embodiment of this application;
FIG. 3 is a schematic diagram of a principle of an analog phase compensation method according to an embodiment of this application;
FIG. 4 is a schematic diagram of a principle of another analog phase compensation method according to an embodiment of this application;
FIG. 5 is a schematic diagram 1 of a structure of a phase compensation apparatus according to an embodiment of this application;
FIG. 6 is a schematic diagram 2 of a structure of a phase compensation apparatus according to an embodiment of this application;
FIG. 7 is a schematic diagram 3 of a structure of a phase compensation apparatus according to an embodiment of this application;
FIG. 8 is a schematic diagram 4 of a structure of a phase compensation apparatus according to an embodiment of this application;
FIG. 9 is a schematic diagram 5 of a structure of a phase compensation apparatus according to an embodiment of this application;
FIG. 10 is a schematic diagram 6 of a structure of a phase compensation apparatus according to an embodiment of this application;
FIG. 11 is a schematic diagram 7 of a structure of a phase compensation apparatus according to an embodiment of this application;
FIG. 12 is a schematic flowchart 1 of a phase compensation method according to an embodiment of this application;
FIG. 13 is a schematic flowchart 2 of a phase compensation method according to an embodiment of this application;
FIG. 14 is a schematic flowchart 3 of a phase compensation method according to an embodiment of this application; and
FIG. 15 is a schematic flowchart 4 of a phase compensation method according to an embodiment of this application.

### DESCRIPTION OF EMBODIMENTS

Currently, to resolve a problem that a signal-to-noise ratio of an output signal of a travelling wave tube is reduced due to phase noise generated by a cathode ripple signal, the following two solutions are provided.

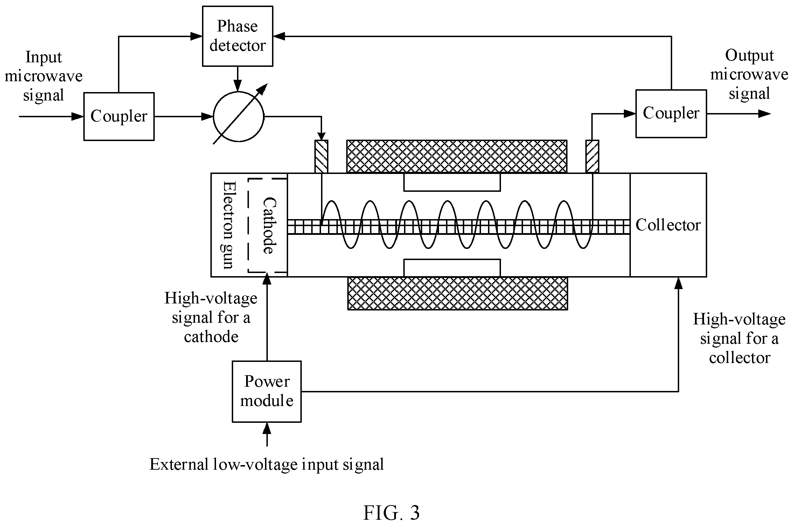

In an implementation, an analog compensation method in which a conventional phase detector is used is provided. As shown in FIG. 3, a basic operating principle is as follows: An input microwave signal is used as a reference signal and is input, by using a coupler, into an analog phase detector together with an output microwave signal with phase noise. The analog phase detector identifies a phase difference between the input microwave signal and the output microwave signal in real time by using an internal complex phase discrimination circuit, and then controls, in real time based on the phase difference, a phase shifter connected in series to an input energy transmission window of the travelling wave tube, to perform phase modulation in real time, so as to compensate for the phase noise.

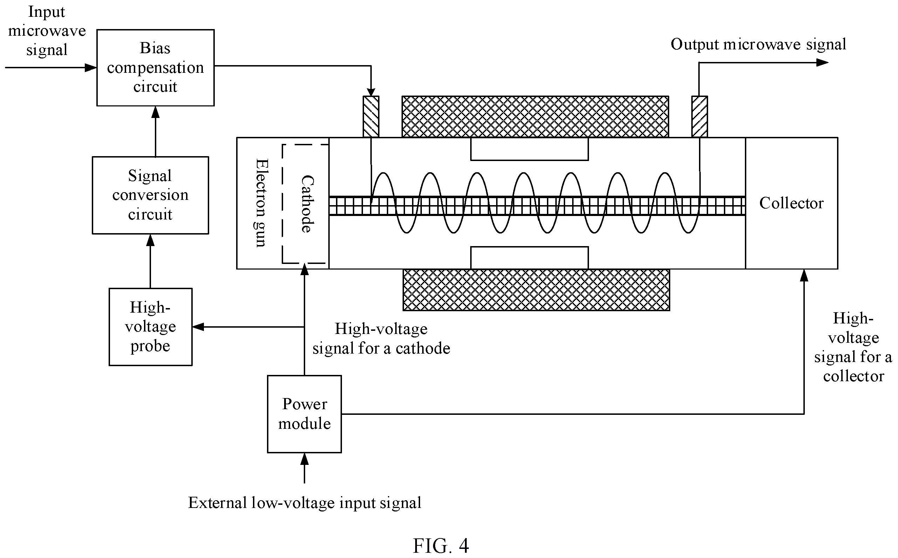

In another implementation, an open-loop pure analog circuit compensation method is provided. As shown in FIG. 4, a basic operating principle is as follows: A high-voltage probe circuit is used to extract a ripple signal from a high-voltage signal for a cathode, the ripple signal is converted into a corresponding compensation voltage signal by using a signal conversion circuit, and then dynamic phase compensation is performed on an input microwave signal by using a bias compensation circuit.

However, through in-depth analysis of the foregoing two solutions, there may be following problems:
(1) In the solution shown in FIG. 3, compensation precision of an analog phase shifter is low, and an adjustment speed is limited. Because a frequency of a microwave signal is high, when the phase shifter is used to perform phase compensation on the microwave signal on a radio frequency channel, high-precision, fast, and real-time compensation for the microwave signal cannot be implemented, resulting in poor compensation effect.
(2) In the solution shown in FIG. 4, pure open-loop compensation is used, that is, impact of a characteristic of the travelling wave tube on a power supply ripple signal is not considered, and the complex bias compensation circuit is used. Consequently, compensation precision is low, and compensation effect is poor.
(3) In the two solutions, phase compensation is implemented by using an analog circuit, for example, the phase shifter in FIG. 3 and the bias compensation circuit in FIG. 4. Complexity of circuit-based implementation is high. In addition, once the two circuits are designed, functions of the circuits are basically fixed, and adaptability to the travelling wave tube is poor. When a plurality of different travelling wave tubes are used in a system, a phase shifter or a bias compensation circuit may need to be separately designed for each travelling wave tube.

In view of this, this application provides a phase compensation apparatus and method, to implement phase compensation on a baseband. This avoids use of a low-precision phase shifter and a complex bias compensation circuit, reduces complexity of a circuit design, and improves phase compensation precision. In addition, applicability of a multi-vacuum-amplifier system is improved based on high flexibility of digital baseband processing.

The following describes technical solutions in embodiments of this application with reference to accompanying drawings in embodiments of this application. In descriptions of this application, "/" represents an "or" relationship between associated objects unless otherwise specified. For example, A/B may represent A or B. In this application, "and/or" describes only an association relationship for describing associated objects and represents that three relationships may exist. For example, A and/or B may represent the following three cases: Only A exists, both A and B exist, and only B exists, where A and B may be singular or plural. In addition, in descriptions of this application, unless otherwise specified, "a plurality of" means two or more than two. At least one of the following items (pieces) or a similar expression thereof indicates any combination of these items, including a single item (piece) or any combination of a plurality of items (pieces). For example, at least one item (piece) of a, b, or c may represent: a, b, c, a and b, a and c, b and c, or a, b, and c, where a, b, and c may be singular or plural.

In addition, to clearly describe technical solutions in embodiments of this application, terms such as "first" and "second" are used in embodiments of this application to distinguish between same items or similar items that provide basically same functions or purposes. A person skilled in the art may understand that the terms such as "first" and "second" do not limit a quantity or an execution sequence, and the terms such as "first" and "second" do not indicate a definite difference.

In addition, in embodiments of this application, terms such as "example" or "for example" are used to represent giving an example, an illustration, or a description. Any embodiment or design scheme described as an "example" or "for example" in embodiments of this application should not be explained as being more preferred or having more advantages than another embodiment or design scheme. Exactly, use of the word such as "example" or "for example" is intended to present a related concept in a specific manner for ease of understanding.

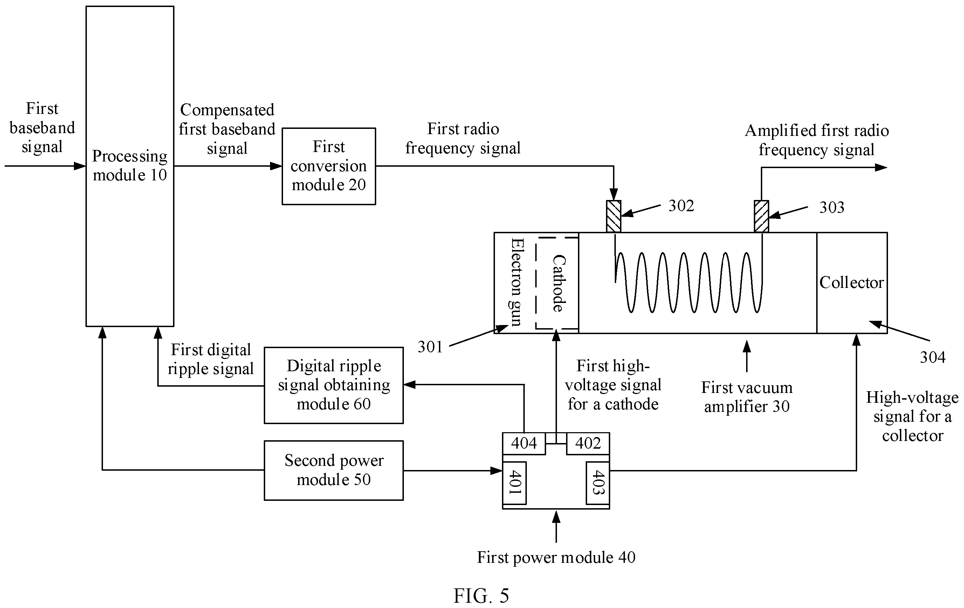

FIG. 5 shows a phase compensation apparatus according to this application. The phase compensation apparatus includes a processing module 10 and a first conversion module 20.

The processing module 10 is a baseband processing module. For example, the processing module 10 may include a baseband chip, and may further include a peripheral circuit of the baseband chip. For example, the peripheral circuit may include one or more of a phase detector, a coupler, an analog-to-digital conversion module, and a digital ripple signal obtaining module in the following embodiments. Certainly, the processing module 10 may further include more or fewer components than those in the foregoing example. A form of the processing module 10 is not specifically limited in this application.

The first conversion module 20 is connected to the processing module 10, and is configured to convert a signal output by the processing module 10.

Optionally, the first conversion module 20 is further connected to a first vacuum amplifier 30, and is configured to output a converted signal to the first vacuum amplifier 30.

It should be noted that a vacuum amplifier in this application may be a travelling wave tube, may be a klystron, or may be another vacuum amplifier component. This is not specifically limited in this application.

Optionally, the first vacuum amplifier 30 includes an electron gun 301, an input energy transmission window 302, an output energy transmission window 303, a collector 304, and a slow-wave structure connected to the input energy transmission window 302 and the output energy transmission window 303. The electron gun 301 includes a cathode. It may be understood that the first vacuum amplifier 30 further includes another component. For example, when the first vacuum amplifier is the travelling wave tube, the first vacuum amplifier 30 may further include a magnetic focusing system, a centralized attenuator, and the like. A specific structure of the first vacuum amplifier 30 is not limited in this application.

Optionally, in this application, a first power module 40 supplies power to the first vacuum amplifier 30. The first power module may be a dedicated power supply of the vacuum amplifier, and includes at least a voltage input interface 401, a voltage output interface 402, a voltage output interface 403, and a low-voltage interface 404. The voltage input interface 401 is configured to convert an external low voltage into an operating voltage required by the first vacuum amplifier 40. The voltage output interface 402 is configured to supply a first high voltage for a cathode to a cathode of the first vacuum amplifier 30. The voltage output interface 403 is configured to supply a high voltage for a collector to a collector of the first vacuum amplifier 30. The low-voltage interface 404 is configured to divide the first high voltage for a cathode, to obtain a low voltage including a ripple voltage signal. Certainly, the first power module 40 may further include a control interface and another interface, for example, an interface that supplies a voltage to a gate electrode, an anode (used to accelerate an electron beam), a focusing electrode (used to focus an electron beam), or the like of the electron gun. This is not specifically limited in this application.

Optionally, an input voltage of the voltage input interface 401 of the first power module 40 may be supplied by a second power module 50. The second power module 50 may further supply power to the processing module 10. Certainly, the second power module 50 may also supply power to the phase compensation apparatus or another circuit module in a system. This is not specifically limited in this application.

Optionally, the first power module 40 and the second power module 50 may be independent power modules, or may be integrated into one power module. This is not specifically limited in this application.

It should be noted that one or more of the first vacuum amplifier 30, the first power module 40, and the second power module 50 may be deployed in the phase compensation apparatus, or may be independently deployed from the phase compensation apparatus, in other words, deployed outside the phase compensation apparatus. This is not specifically limited in this application.

For the phase compensation apparatus that includes the processing module 10 and the first conversion module 20 shown in FIG. 5,
the processing module 10 is configured to perform phase compensation on a first baseband signal based on a first digital ripple signal, to obtain a compensated first baseband signal. The first digital ripple signal is obtained based on a ripple signal of the first high voltage for a cathode, and the first high voltage for a cathode is used to supply power to the cathode of the first vacuum amplifier 30. The first conversion module 20 is configured to convert the compensated first baseband signal into a first radio frequency signal.

As shown in FIG. 5, the first baseband signal and the first digital ripple signal are input to the processing module 10. After obtaining the compensated first baseband signal, the processing module 10 outputs the compensated first baseband signal to the first conversion module 20, and the first conversion module 20 converts the compensated first baseband signal into the first radio frequency signal.

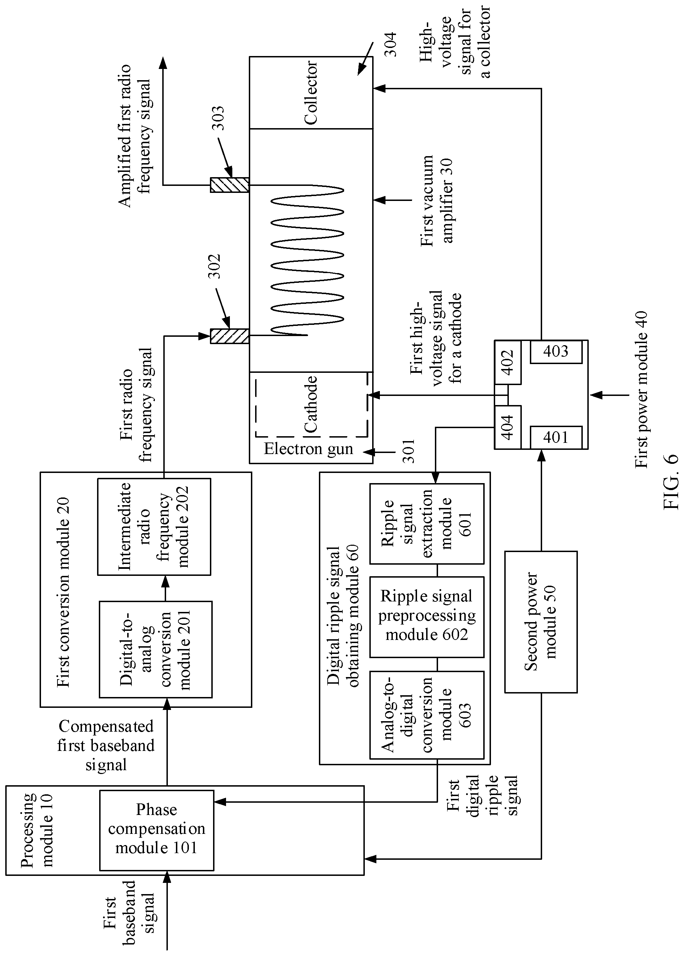

Optionally, as shown in FIG. 6, the processing module 10 includes a phase compensation module 101. That the processing module 10 is configured to perform phase compensation on the first baseband signal based on the first digital ripple signal, to obtain the compensated first baseband signal includes: The phase compensation module 101 is configured to perform phase compensation on the first baseband signal based on the first digital ripple signal, to obtain the compensated first baseband signal.

Optionally, as shown in FIG. 6, the first conversion module 20 includes a digital-to-analog conversion module 201 and an intermediate radio frequency module 202. That the first conversion module 20 is configured to convert the compensated first baseband signal into the first radio frequency signal may include: The digital-to-analog conversion module 201 is configured to: convert the compensated first baseband signal into a compensated first analog signal, and output the compensated first analog signal to the intermediate radio frequency module 202. The intermediate radio frequency module 202 is configured to: up-convert the compensated first analog signal to a radio frequency signal, and implement processing such as filtering and amplification, to meet drive power of an input signal of the first vacuum amplifier 30, and finally output the first radio frequency signal.

Optionally, the first conversion module 20 is further configured to output the first radio frequency signal to the first vacuum amplifier 30, that is, output the first radio frequency signal to the input energy transmission window 302 of the first vacuum amplifier 30. After the first vacuum amplifier 30 amplifies the first radio frequency signal, an amplified first radio frequency signal is output through the output energy transmission window 303.

Optionally, the first digital ripple signal is obtained by a digital ripple signal obtaining module 60. When the first high voltage for a cathode is an analog voltage, as shown in FIG. 6, the digital ripple signal obtaining module 60 may include a ripple signal extraction module 601, a ripple signal preprocessing module 602, and an analog-to-digital conversion module 603.

The ripple signal extraction module 601 is configured to extract the ripple voltage signal in the low voltage output by the low-voltage interface 404 of the first power module 40, and the ripple voltage signal is the ripple signal of the first high voltage for a cathode. Optionally, the ripple signal extraction module 601 may be further integrated in the first power module 40. In this case, the digital ripple signal extraction module 60 does not include the ripple signal extraction module 601.

The ripple signal preprocessing module 602 is configured to perform preprocessing on the ripple signal that is of the first high voltage for a cathode and that is extracted by the ripple signal extraction module 601, to obtain a first analog ripple signal, and the preprocessing is used to adapt to an operating range of the analog-to-digital conversion module 603. That is, the ripple signal preprocessing module 602 performs processing such as amplification on the ripple signal of the first high voltage for a cathode, so that the first analog ripple signal output by the ripple signal preprocessing module 602 adapts to the operating range of the analog-to-digital conversion module 603, to improve precision of quantizing the ripple signal of the first high voltage for a cathode into the first digital ripple signal.

The analog-to-digital conversion module 603 is configured to convert the first analog ripple signal into a first digital ripple signal that can be processed on a digital baseband.

It should be noted that the analog-to-digital conversion module 603 may be referred to as a second analog-to-digital conversion module, and a first analog-to-digital conversion module is described in the following embodiment. Details are not described herein again.

Based on the phase compensation apparatus, the processing module can perform phase compensation on the first baseband signal on a baseband based on a digital ripple signal (namely, the first digital ripple signal) corresponding to the first high voltage for a cathode, the first conversion module converts the compensated first baseband signal into the first radio frequency signal, and the first radio frequency signal may be amplified by the vacuum amplifier and then output to a load. This avoids use of a low-precision phase shifter and a complex bias compensation circuit on a radio frequency band, reduces complexity of a circuit design, and improves phase compensation precision based on high flexibility of baseband processing.

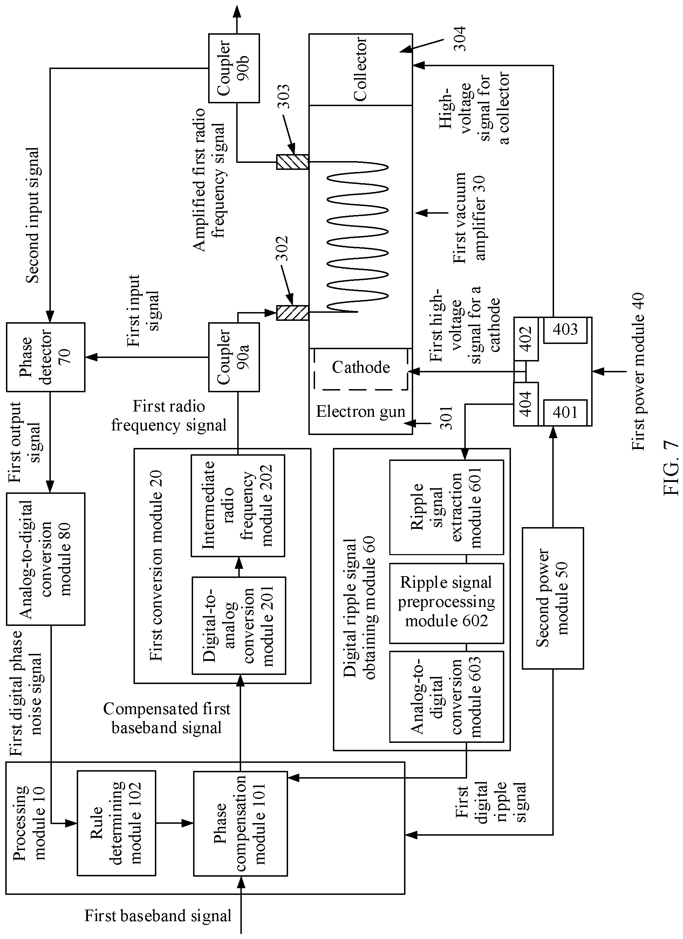

Optionally, as shown in FIG. 7, the phase compensation apparatus further includes a phase detector 70, an analog-to-digital conversion module 80, a coupler 90a, and a coupler 90b.

It should be noted that the analog-to-digital conversion module 80 may be referred to as the first analog-to-digital conversion module. Unified descriptions are provided herein and details are not described in the following embodiment again.

Optionally, the coupler 90a is located at an input of the first vacuum amplifier 30, and is configured to: couple an original input signal of the first vacuum amplifier 30 and use the coupled original input signal as a first input signal of the phase detector 70. The coupler 90b is located at an output of the first vacuum amplifier 30, and is configured to: couple an original output signal of the first vacuum amplifier 30 and use the coupled original output signal as a second input signal of the phase detector 70. The phase detector 70 outputs a first output signal, that is, a phase difference signal between the first input signal and the second input signal, based on the first input signal and the second input signal.

It should be noted that in this application, the original input signal of the first vacuum amplifier 30 is a radio frequency signal on which phase compensation is not performed, and the original output signal of the first vacuum amplifier 30 is an output signal obtained when the input signal of the first vacuum amplifier 30 is the original input signal. Optionally, the original input signal may be a signal obtained after a first reference baseband signal is converted by the first conversion module 20 in this application, or may be another radio frequency signal on which phase compensation is not performed. This is not specifically limited in this application.

Optionally, the first reference baseband signal may meet the following features: A signal bandwidth of the first reference baseband signal is the same as a bandwidth of the first baseband signal, and/or a modulation mode of the first reference baseband signal is the same as a modulation mode of the first baseband signal.

Optionally, the first output signal of the phase detector 70 may be output to the processing module 10 by using the analog-to-digital conversion module 80, to be specific, after analog-to-digital conversion is performed on the first output signal of the phase detector 70 by using the analog-to-digital conversion module 80, a converted first output signal is output to the processing module 10. In the following embodiment of this application, a signal obtained after the first input signal of the phase detector 70 is output to the processing module 10 by using the analog-to-digital conversion module 80 is referred to as a first digital phase noise signal.

In this scenario, before phase compensation is performed, the processing module 10 is further configured to determine a first phase compensation rule based on the first digital phase noise signal and a second digital ripple signal. The first phase compensation rule is used for phase compensation for the first baseband signal. Specifically, the first phase compensation rule is used to determine a phase compensation signal. The second digital ripple signal is obtained based on a ripple signal of a second high voltage for a cathode, and the second high voltage for a cathode is used to supply power to the cathode of the first vacuum amplifier 30 before the first high voltage for a cathode.

Optionally, the second high voltage for a cathode may be output by the first power module 40. The second high voltage for a cathode may be the same as or different from the first high voltage for a cathode. This is not specifically limited in this application. For a method for obtaining the second digital ripple signal based on the ripple signal of the second high voltage for a cathode, refer to a method for obtaining the first digital ripple signal. Details are not described herein again.

In view of this, that the processing module 10 is configured to perform phase compensation on the first baseband signal based on the first digital ripple signal, to obtain the compensated first baseband signal may include: The processing module 10 is configured to determine a first phase compensation signal based on the first digital ripple signal and the first phase compensation rule; and the processing module 10 is further configured to perform phase compensation on the first baseband signal based on the first phase compensation signal, to obtain the compensated first baseband signal.

That is, before performing phase compensation, the phase compensation apparatus may first determine a phase compensation rule, and then perform phase compensation based on the phase compensation rule. In addition, when determining the phase compensation rule, the phase detector feeds back phase noise based on the original input signal and the original output signal of the vacuum amplifier, and impact of a characteristic of the vacuum amplifier on a power supply ripple signal is considered, so that the phase compensation signal determined based on the phase compensation rule is more accurate, to further improve phase compensation precision.

Optionally, in an implementation scenario of this application, the first phase compensation rule is a first model. In this case, that the processing module 10 is configured to determine the first phase compensation rule based on the first digital phase noise signal and the second digital ripple signal may include: The processing module 10 is configured to establish the first model by using the second digital ripple signal as a model input and the first digital phase signal noise as a model output. The first model is a mathematical model, and a model establishment method may be a conventional mathematical modeling method, or may be a neural network modeling method or an artificial intelligence (artificial intelligence, AI) modeling method. The modeling method is not specifically limited in this application.

Correspondingly, when the first phase compensation rule is the first model, that the processing module 10 is configured to determine the first phase compensation signal based on the first digital ripple signal and the first phase compensation rule may include: The processing module 10 is configured to input the first digital ripple signal into the first model, to obtain the first phase compensation signal.

Optionally, as shown in FIG. 7, the processing module 10 further includes a rule determining module 102, and an action that is related to determining the first phase compensation rule and that is performed by the processing module may be performed by the rule determining module 102. The rule determining module 102 may be a model establishment module. In this case, the first phase compensation rule is the first model.

In conclusion, in the phase compensation apparatus in this application, the phase compensation rule may be first determined based on the first digital phase noise signal fed back by the phase detector 70 and the digital ripple signal, and then feedback of the phase detector 70 is disabled. In a phase compensation stage, a phase compensation signal corresponding to a high voltage for a cathode is determined based on a previously determined phase compensation rule, and then a baseband signal is compensated based on the phase compensation signal, to obtain a compensated baseband signal.

In an implementation scenario of this application, the phase compensation apparatus may be used in a scenario with a plurality of vacuum amplifiers. In the following embodiment, two vacuum amplifiers are used as an example for description.

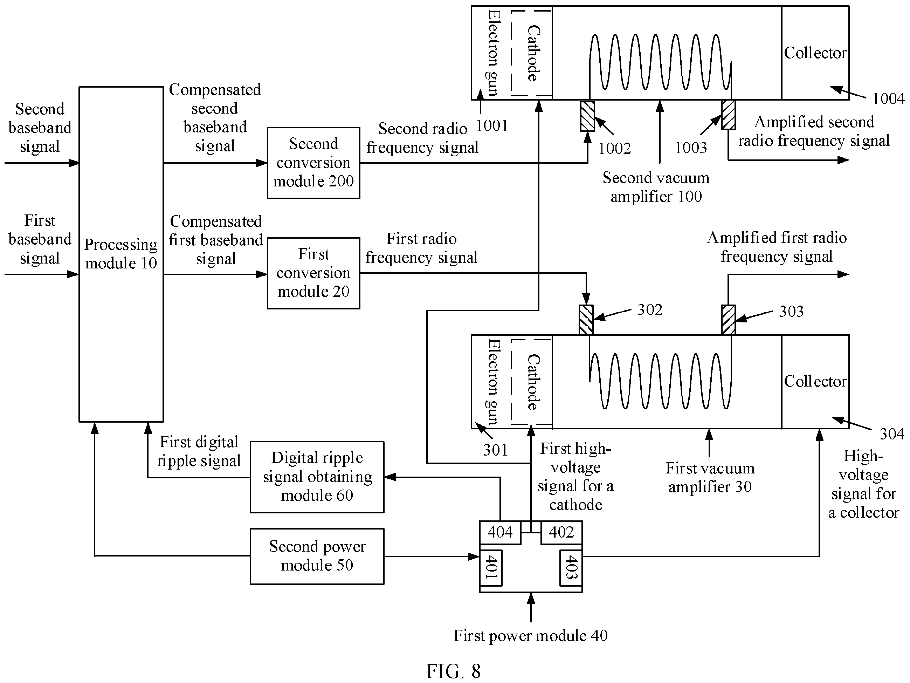

As shown in FIG. 8, the phase compensation apparatus further includes a second conversion module 200. The second conversion module 200 is connected to the processing module 10, and is configured to convert the signal output by the processing module 10.

Optionally, the second conversion module 200 is further connected to a second vacuum amplifier 100, and is configured to output a converted signal to the second vacuum amplifier 100. The second vacuum amplifier 100 includes an electron gun 1001, an input energy transmission window 1002, an output energy transmission window 1003, a collector 1004, and a slow-wave structure connected to the input energy transmission window 1002 and the output energy transmission window 1003. Refer to related descriptions of the first vacuum amplifier 30, and details are not described herein again.

Optionally, in this scenario, the first high voltage for a cathode is further used to supply power to a cathode of the second vacuum amplifier 100. That is, the first vacuum amplifier 30 and the second vacuum amplifier 100 have a same high voltage for a cathode.

It should be noted that a type of the second vacuum amplifier in this application may be the same as or different from a type of the first vacuum amplifier. This is not specifically limited in this application.

In this scenario, the processing module 10 is further configured to perform phase compensation on a second baseband signal based on the first digital ripple signal, to obtain a compensated second baseband signal. The second conversion module 101 is configured to convert the compensated first baseband signal into the first radio frequency signal.

As shown in FIG. 8, the second baseband signal and the first digital ripple signal are input to the processing module 10. After obtaining the compensated second baseband signal, the processing module 10 outputs the compensated second baseband signal to the second conversion module 200, and the second conversion module 200 converts the compensated second baseband signal into the second radio frequency signal.

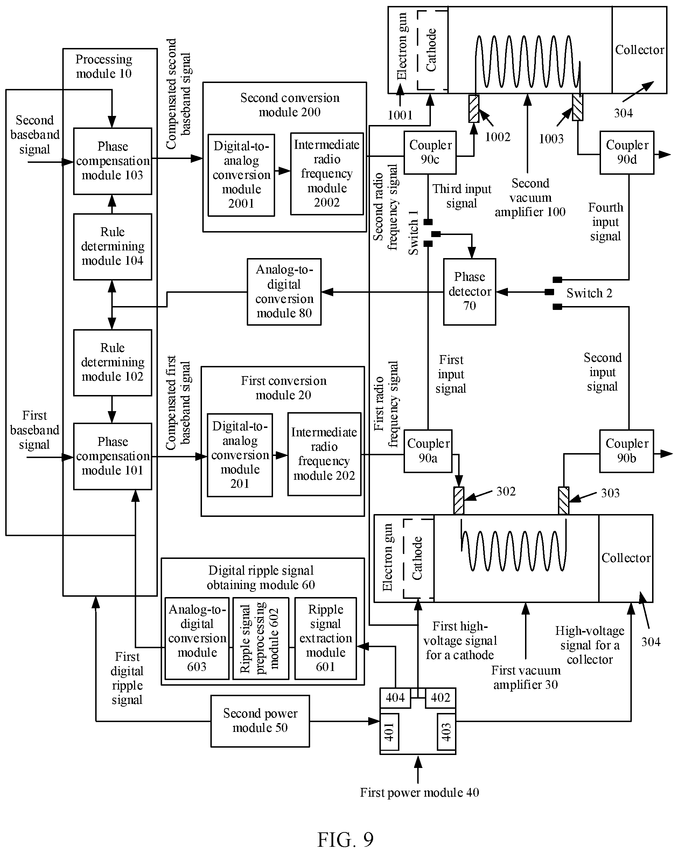

Optionally, as shown in FIG. 9, the processing module 10 includes a phase compensation module 103. That the processing module 10 is configured to perform phase compensation on the second baseband signal based on the first digital ripple signal, to obtain the compensated second baseband signal includes: The phase compensation module 103 is configured to perform phase compensation on the second baseband signal based on the first digital ripple signal, to obtain the compensated second baseband signal.

Optionally, as shown in FIG. 9, the second conversion module 200 includes a digital-to-analog conversion module 2001 and an intermediate radio frequency module 2002. That the second conversion module 200 is configured to convert the compensated second baseband signal into the second radio frequency signal may include: The digital-to-analog conversion module 2001 is configured to: convert the compensated second baseband signal into a compensated second analog signal, and output the compensated second analog signal to the intermediate radio frequency module 2002. The intermediate radio frequency module 2002 is configured to: up-convert the compensated second analog signal to a radio frequency signal, and implement processing such as filtering and amplification, to meet drive power of an input signal of the second vacuum amplifier 200, and finally output the second radio frequency signal.

Optionally, the second conversion module 200 is further configured to output the second radio frequency signal to the second vacuum amplifier 100, that is, output the second radio frequency signal to the input energy transmission window 1002 of the second vacuum amplifier 30. After the second vacuum amplifier 100 amplifies the second radio frequency signal, an amplified second radio frequency signal is output through the output energy transmission window 1003.

Based on the phase compensation apparatus, a same processing module can be used to perform phase compensation on a plurality of baseband signals used in a plurality of vacuum amplifiers, and a phase compensation circuit does not need to be separately designed for each vacuum amplifier, so that adaptability and practicability are high. In addition, the plurality of vacuum amplifiers are powered by using a common power module, and a common digital ripple signal obtaining module is used. This reduces circuit complexity.

Optionally, as shown in FIG. 9, the phase compensation apparatus further includes a switch 1, a switch 2, a coupler 90c, and a coupler 90d. The switch 1 and the switch 2 are configured to select an input signal of the phase detector 70. The coupler 90c is located at an input of the second vacuum amplifier 100. When the switch 1 is connected to the coupler 90c, the coupler 90c is configured to: couple an original input signal of the second vacuum amplifier 100 and use the coupled original input signal as a third input signal of the phase detector 70. The coupler 90d is located at an output of the second vacuum amplifier 100. When the switch 2 is connected to the coupler 90d, the coupler 90d is configured to: couple an original output signal of the second vacuum amplifier 100 and use the coupled original output signal as a fourth input signal of the phase detector 70. The phase detector 70 outputs a second output signal, that is, a phase difference signal between the third input signal and the fourth input signal, based on the third input signal and the fourth input signal.

It should be noted that in this application, the original input signal of the second vacuum amplifier 100 is a radio frequency signal on which phase compensation is not performed, and the original output signal of the second vacuum amplifier 100 is an output signal obtained when the input signal of the second vacuum amplifier 100 is the original input signal. Optionally, the original input signal may be a signal obtained after a second reference baseband signal is converted by the second conversion module 200 in this application, or may be another radio frequency signal on which phase compensation is not performed. This is not specifically limited in this application.

Optionally, the second reference baseband signal may meet the following features: A signal bandwidth of the second reference baseband signal is the same as a bandwidth of the second baseband signal, and/or a modulation mode of the second reference baseband signal is the same as a modulation mode of the second baseband signal.

Optionally, the second output signal of the phase detector 70 may be output to the processing module 10 by using the analog-to-digital conversion module 80, to be specific, after analog-to-digital conversion is performed on the second output signal of the phase detector 70 by using the analog-to-digital conversion module 80, a converted second output signal is output to the processing module 10. In the following embodiment of this application, a signal obtained after the second input signal of the phase detector 70 is output to the processing module 10 by using the analog-to-digital conversion module 80 is referred to as a second digital phase noise signal.

In this scenario, before phase compensation is performed, the processing module 10 is further configured to determine a second phase compensation rule based on the second digital phase noise signal and the second digital ripple signal. The second phase compensation rule is used for phase compensation for the second baseband signal. Specifically, the second phase compensation rule is used to determine a phase compensation signal.

In view of this, that the processing module 10 is configured to perform phase compensation on the second baseband signal based on the first digital ripple signal, to obtain the compensated second baseband signal may include: The processing module 10 is configured to determine a second phase compensation signal based on the first digital ripple signal and the second phase compensation rule; and the processing module 10 is further configured to perform phase compensation on the second baseband signal based on the second phase compensation signal, to obtain the compensated second baseband signal.

That is, before performing phase compensation on the baseband signals used in the plurality of vacuum amplifiers, the phase compensation apparatus may first determine a phase compensation rule corresponding to each vacuum amplifier, and then perform phase compensation on each baseband signal based on each phase compensation rule.

Optionally, in an implementation scenario of this application, the second phase compensation rule is a second model. In this case, that the processing module 10 is configured to determine the second phase compensation rule based on the second digital phase noise signal and the second digital ripple signal may include: The processing module 10 is configured to establish the second model by using the second digital ripple signal as a model input and the second digital phase signal noise as a model output. For related descriptions of the second model, refer to the first model. Details are not described herein again.

Correspondingly, when the second phase compensation rule is the second model, that the processing module 10 is configured to determine the second phase compensation signal based on the first digital ripple signal and the second phase compensation rule may include: The processing module 10 is configured to input the first digital ripple signal into the second model, to obtain the second phase compensation signal.

Optionally, as shown in FIG. 9, the processing module 10 further includes a rule determining module 104, and an action that is related to determining the second phase compensation rule and that is performed by the processing module may be performed by the rule determining module 104.

Based on the phase compensation apparatus, a same phase detector and processing module can be used to determine phase compensation rules corresponding to the plurality of vacuum amplifiers, and a phase detector does not need to be separately deployed for each vacuum amplifier, to feed back a phase difference of the vacuum amplifier. Therefore, adaptability and practicability are high in a scenario with the plurality of vacuum amplifiers.

It should be noted that, in FIG. 8 and FIG. 9, only an example in which there are two vacuum amplifiers is used to describe the phase compensation apparatus in this application. In an actual application, the phase compensation apparatus may be further used in a scenario in which there are more than two vacuum amplifiers. In the scenario in which there are more than two vacuum amplifiers, a high voltage for a cathode of each vacuum amplifier is supplied by a same power module, and each vacuum amplifier may also share a phase detector.

In another implementation scenario of this application, the first vacuum amplifier 30 may be a multi-channel vacuum amplifier. In the following embodiment, an example in which the first vacuum amplifier 30 includes two channels is used for description.

It should be noted that the multi-channel vacuum amplifier in this application includes a plurality of input-output energy transmission window pairs, and each input-output energy transmission window pair is connected to one channel (for example, a slow-wave structure). This is uniformly described herein, and details are not described in the following embodiment.

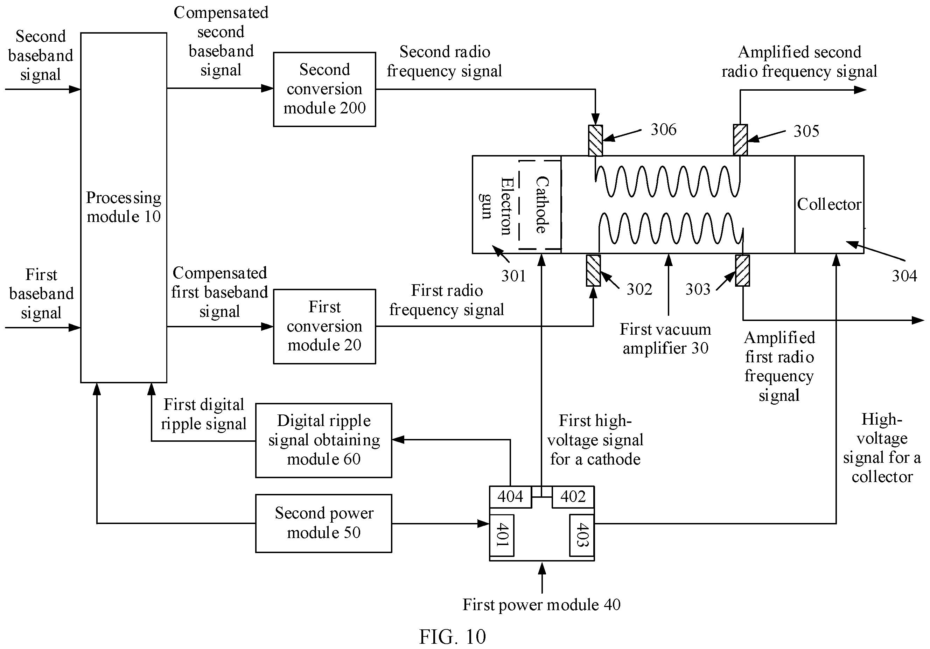

As shown in FIG. 10, the input energy transmission window 302 is referred to as a first input energy transmission window 302, the output energy transmission window 303 is referred to as a first output energy transmission window 303, and the slow-wave structure connected to the input energy transmission window 302 and the output energy transmission window 303 is referred to as a first slow-wave structure. In addition, the first vacuum amplifier 30 further includes a second input energy transmission window 306, a second output energy transmission window 305, and a second slow-wave structure connected to the second input energy transmission window 305 and the second output energy transmission window 306. The phase compensation apparatus further includes the second conversion module 200. Refer to related descriptions in FIG. 8. Details are not described herein again.

In this scenario, the processing module 10 is further configured to perform phase compensation on a second baseband signal based on the first digital ripple signal, to obtain a compensated second baseband signal. The second conversion module 101 is configured to convert the compensated first baseband signal into the first radio frequency signal.

Optionally, the second conversion module 200 is further configured to output a second radio frequency signal to the second input energy transmission window 306 of the first vacuum amplifier 30. After the second radio frequency signal is amplified through a channel that is in the first vacuum amplifier 30 and that is connected to the second input energy transmission window 306, an amplified second radio frequency signal is output through the second output energy transmission window 305. The first conversion module 20 is further configured to output the first radio frequency signal to the first input energy transmission window 302 of the first vacuum amplifier 30. After the first radio frequency signal is amplified through a channel that is in the first vacuum amplifier 30 and that is connected to the first input energy transmission window 302, an amplified first radio frequency signal is output through the first output energy transmission window 303.

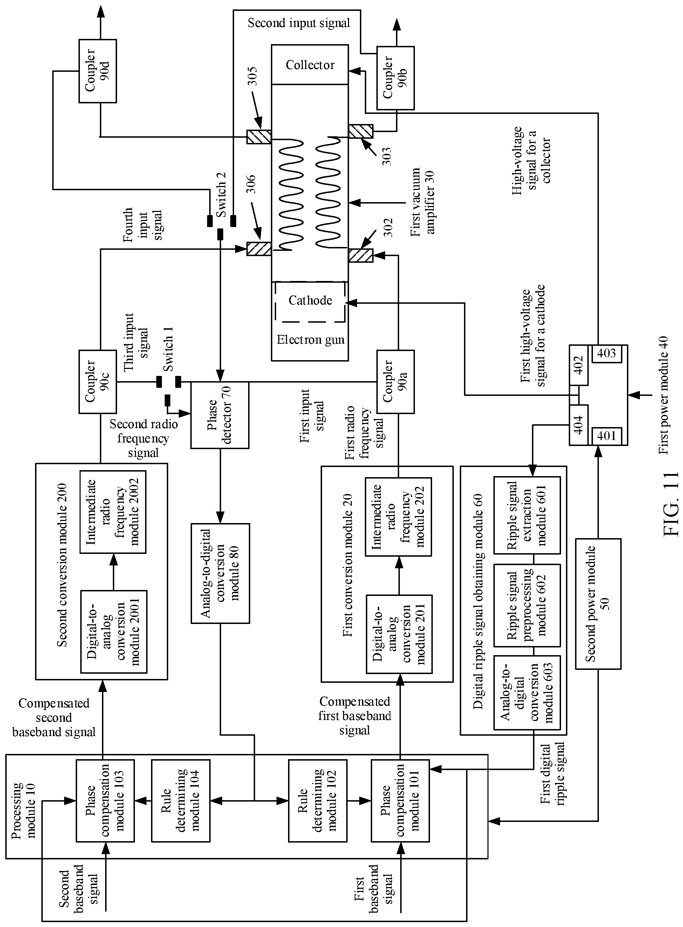

Optionally, as shown in FIG. 11, the phase compensation apparatus further includes a switch 1, a switch 2, a coupler 90c, and a coupler 90d. The switch 1 and the switch 2 are configured to select an input signal of the phase detector 70. The coupler 90c is located on a side of the second input energy transmission window 306 of the first vacuum amplifier 30. When the switch 1 is connected to the coupler 90c, the coupler 90c is configured to: couple an original input signal of the second input energy transmission window 306 and use the coupled original input signal as a third input signal of the phase detector 70. The coupler 90d is located on a side of the second output energy transmission window 305 of the first vacuum amplifier 30. When the switch 2 is connected to the coupler 90d, the coupler 90d is configured to: couple an original output signal of the second output energy transmission window 305 and use the coupled original output signal as a fourth input signal of the phase detector 70. The phase detector 70 outputs a second output signal, that is, a phase difference signal between the third input signal and the fourth input signal, based on the third input signal and the fourth input signal.

In addition, the coupler 90a is located on a side of the first input energy transmission window 302 of the first vacuum amplifier 30, and is configured to: couple an original input signal of the first input energy transmission window 302 and use the coupled original input signal as the first input signal of the phase detector 70. The coupler 90b is located on a side of the first output energy transmission window 303 of the first vacuum amplifier 30, and is configured to: couple an original output signal of the first output energy transmission window 303 and use the coupled original output signal as the second input signal of the phase detector 70.

It should be noted that in this application, the original input signal of the second input energy transmission window 306 is a radio frequency signal on which phase compensation is not performed, and the original output signal of the second output energy transmission window 306 is an output signal obtained when the input signal of the second input energy transmission window 306 is the original input signal. Optionally, the original input signal may be a signal obtained after a second reference baseband signal is converted by the second conversion module 200 in this application, or may be another radio frequency signal on which phase compensation is not performed. This is not specifically limited in this application. Refer to related descriptions of the second reference baseband signal in the scenario with the plurality of vacuum amplifiers, and details are not described herein again. The original input signal of the first input energy transmission window 302 is the original input signal of the first vacuum amplifier 30 in FIG. 7. Refer to the foregoing related description, and details are not described herein again.

In this scenario, before phase compensation is performed, for an implementation in which the processing module 10 determines the second phase compensation rule and performs phase compensation on the second baseband signal based on the first digital ripple signal, refer to related descriptions in FIG. 9. Details are not described herein again.

Optionally, in an implementation scenario of this application, the second phase compensation rule is a second model. In this case, for implementation in which the processing module 10 determines the second model and determines the second phase compensation signal, refer to related descriptions in FIG. 9. Details are not described herein again.

Based on the phase compensation apparatus, a same phase detector and processing module can be used to determine phase compensation rules corresponding to a plurality of channels of the vacuum amplifier, and a phase detector does not need to be separately deployed for each channel, to feed back a phase difference of the vacuum amplifier. Therefore, adaptability and practicability are high in a scenario in which the vacuum amplifier includes the plurality of channels.

It should be noted that, in FIG. 10 and FIG. 11, only an example in which the vacuum amplifier includes two channels is used to describe the phase compensation apparatus in this application. In an actual application, the phase compensation apparatus may alternatively be used in a scenario in which the vacuum amplifier includes more than two channels.

Optionally, the phase detector may include a frequency mixer, a 90-degree phase shifter, and a low-pass filter, and may further include an amplifier. A specific result of the phase detector is not limited in this application.

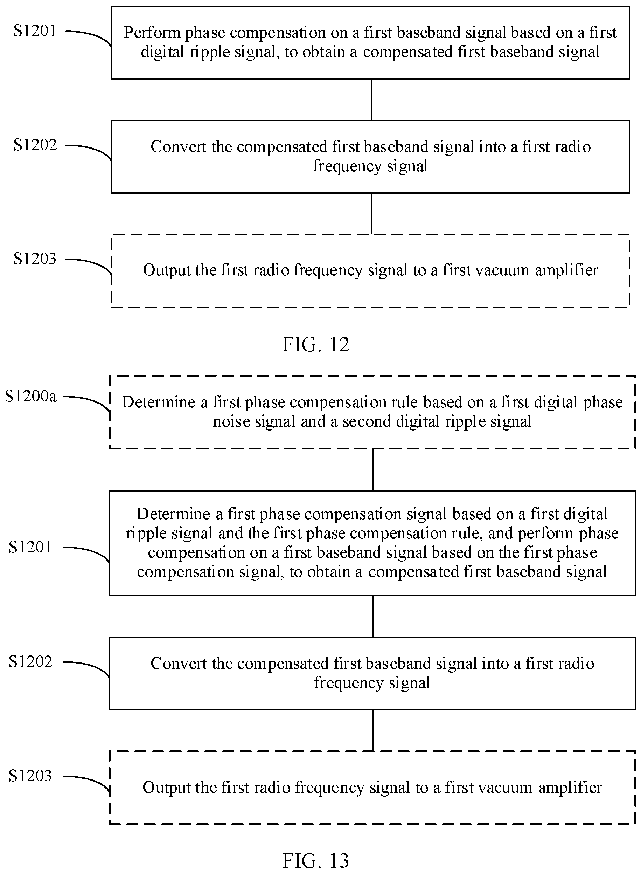

An embodiment of this application further provides a phase compensation method. The phase compensation method is applied to the foregoing phase compensation apparatus, or performed by the foregoing phase compensation apparatus. As shown in FIG. 12, the phase compensation method includes the following steps.

S1201: Perform phase compensation on a first baseband signal based on a first digital ripple signal, to obtain a compensated first baseband signal.

The first digital ripple signal is obtained based on a ripple signal of a first high voltage for a cathode, and the first high voltage for a cathode is used to supply power to a cathode of a first vacuum amplifier. The first vacuum amplifier may be, for example, a travelling wave tube amplifier or a klystron amplifier. This is not specifically limited in this application.

Optionally, obtaining the first digital ripple signal based on the ripple signal of the first high voltage for a cathode may include: extracting the ripple signal of the first high voltage for a cathode, performing preprocessing on the ripple signal of the first high voltage for a cathode, to obtain a first analog ripple signal, and performing analog-to-digital conversion on the first analog ripple signal, to obtain the first digital ripple signal. The preprocessing is used to adapt to an operating range of analog-to-digital conversion.

S1202: Convert the compensated first baseband signal into a first radio frequency signal.

Optionally, converting the compensated first baseband signal into the first radio frequency signal may include: performing digital-to-analog conversion on the first baseband signal, to obtain a compensated first analog signal, and performing processing such as up-conversion, filtering, and amplification on the compensated first analog signal, to obtain the first radio frequency signal.

Optionally, after the first radio frequency signal is obtained, the phase compensation method may further include step 1203.

S1203: Output the first radio frequency signal to the first vacuum amplifier.

Optionally, outputting the first radio frequency signal to the first vacuum amplifier may include: outputting the first radio frequency signal to an input energy transmission window of the first vacuum amplifier. Then, the first vacuum amplifier may amplify the first radio frequency signal, and output an amplified first radio frequency signal.

Based on this solution, phase compensation may be performed on the first baseband signal on a baseband based on a digital ripple signal (namely, the first digital ripple signal) corresponding to the first high voltage for a cathode, the compensated first baseband signal may be converted into the first radio frequency signal, and the first radio frequency signal may be amplified by the vacuum amplifier and then output to a load. This avoids use of a low-precision phase shifter and a complex bias compensation circuit on a radio frequency band, reduces complexity of a circuit design, and improves phase compensation precision based on high flexibility of baseband processing.

In an implementation scenario of this application, as shown in FIG. 13, before the step S1201, the phase compensation method may further include step S 1200a.

S1200a: Determine a first phase compensation rule based on a first digital phase noise signal and a second digital ripple signal.

The first phase compensation rule is used for phase compensation for the first baseband signal. Optionally, the first phase compensation rule is used to determine a phase compensation signal.

The first digital phase noise signal is obtained based on a first output signal of a phase detector. When an output of the phase detector is the first output signal, a first input signal of the phase detector is an original input signal of the first vacuum amplifier, and a second input signal is an original output signal of the first vacuum amplifier. Refer to the foregoing related description. Details are not described herein again.

The second digital ripple signal is obtained based on a ripple signal of a second high voltage for a cathode, and the second high voltage for a cathode is used to supply power to the cathode of the first vacuum amplifier before the first high voltage for a cathode.

In this scenario, the step S1201 may include: determining a first phase compensation signal based on the first digital ripple signal and the first phase compensation rule, and performing phase compensation on the first baseband signal based on the first phase compensation signal, to obtain the compensated first baseband signal.

Optionally, the first phase compensation rule may be a first model. In this case, determining the first phase compensation rule based on the first digital phase noise signal and the second digital ripple signal may include: establishing the first model by using the second digital ripple signal as a model input and the first digital phase noise signal as a model output. Correspondingly, in the step S1201, determining the first phase compensation signal based on the first digital ripple signal and the first phase compensation rule may include: inputting the first digital ripple signal into the first model, to obtain the first phase compensation signal.

Based on this solution, before performing phase compensation, the phase compensation apparatus may first determine a phase compensation rule, and then perform phase compensation based on the phase compensation rule. In addition, when determining the phase compensation rule, impact of a characteristic of the vacuum amplifier on a power supply ripple signal is considered, so that the phase compensation signal determined based on the phase compensation rule is more accurate, to further improve phase compensation precision.

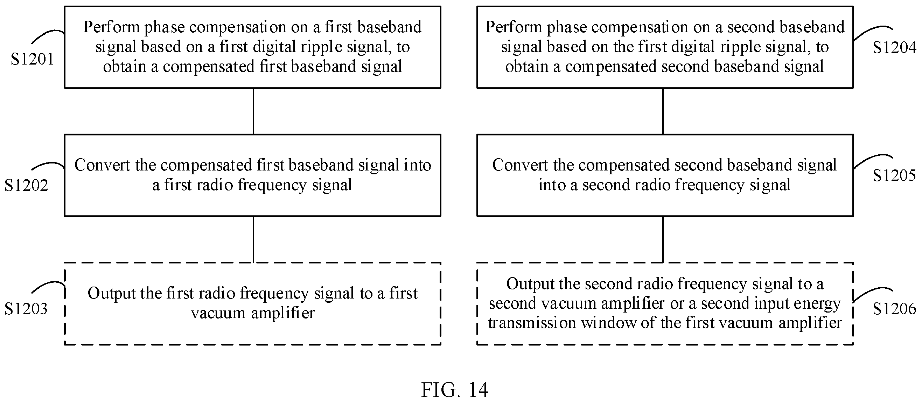

In an implementation scenario of this application, as shown in FIG. 14, the phase compensation method further includes the following steps.

S1204: Perform phase compensation on a second baseband signal based on the first digital ripple signal, to obtain a compensated second baseband signal.

S1205: Convert the compensated second baseband signal into a second radio frequency signal.

Optionally, after the second radio frequency signal is obtained, the phase compensation method may further include step 1206.

S1206: Output the second radio frequency signal to a second vacuum amplifier or a second input energy transmission window of the first vacuum amplifier.

Optionally, when the first high voltage for a cathode is further used to supply power to the second vacuum amplifier, the step S1206 is that: The second radio frequency signal is output to the second vacuum amplifier, and then the second vacuum amplifier may amplify the second radio frequency signal, and output an amplified second radio frequency signal. Alternatively, when the first vacuum amplifier includes a first input energy transmission window and the second input energy transmission window, the step S1206 is that: The second radio frequency signal is output to the second input energy transmission window of the first vacuum amplifier, then the second radio frequency signal may be amplified through a channel (for example, a slow-wave structure) that is in the first vacuum amplifier and that is connected to the second input energy transmission window, and an amplified second radio frequency signal is output through a second output energy transmission window corresponding to the second input energy transmission window.

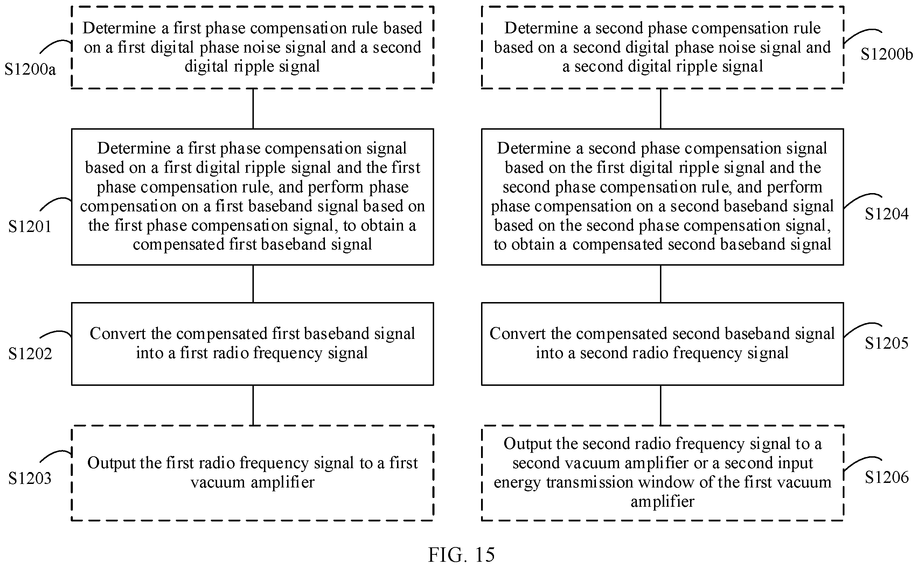

In an implementation scenario of this application, as shown in FIG. 15, before the step S1204, the phase compensation method may further include step S1200b.

S1200b: Determine a second phase compensation rule based on a second digital phase noise signal and the second digital ripple signal.

The second phase compensation rule is used for phase compensation for the second baseband signal. Optionally, the second phase compensation rule is used to determine a phase compensation signal.

The second digital phase noise signal is obtained based on a second output signal of the phase detector. When the output of the phase detector is the second output signal, the following cases may exist:

In a possible implementation, when the first high voltage for a cathode is further used to supply power to a cathode of the second vacuum amplifier, the second high voltage for a cathode is further used to supply power to the cathode of the second vacuum amplifier before the first high voltage for a cathode. In this case, a third input signal of the phase detector is an original input signal of the second vacuum amplifier, and a fourth input signal is an original output signal of the second vacuum amplifier. Refer to the foregoing related description, and this is not specifically limited herein.

In another possible implementation, when the first vacuum amplifier includes the first input energy transmission window and the second input energy transmission window, a third input signal of the phase detector is an original input signal of the second input energy transmission window of the first vacuum amplifier, and a fourth input signal is an original output signal of the second output energy transmission window corresponding to the second input energy transmission window.

In this scenario, the step S1204 may include: determining a second phase compensation signal based on the first digital ripple signal and the second phase compensation rule, and performing phase compensation on the second baseband signal based on the second phase compensation signal, to obtain the compensated second baseband signal.

Optionally, the second phase compensation rule may be a second model. In this case, determining the second phase compensation rule based on the second digital phase noise signal and the second digital ripple signal may include: establishing the second model by using the second digital ripple signal as a model input and the second digital phase noise signal as a model output. Correspondingly, in the step S1204, determining the second phase compensation signal based on the first digital ripple signal and the second phase compensation rule may include: inputting the first digital ripple signal into the second model, to obtain the second phase compensation signal.

Based on this solution, in a scenario in which there are a plurality of vacuum amplifiers or the vacuum amplifier includes a plurality of channels, before phase compensation is performed on a baseband signal, a phase compensation rule corresponding to each vacuum amplifier or each channel may be first determined, and then phase compensation is separately performed on each baseband signal based on each phase compensation rule.

It should be noted that there is no necessary sequence between the step S1201 and the step S1204. The step S1201 may be performed before the step S 1204; the step S1204 may be performed before the step S 1201; or the step S1201 and the step S1204 may be simultaneously performed. In addition, there is no necessary sequence between the step S1200a and the step S1200b. The step S1200a may be performed before the step S1200b; or the step S1200b may be performed before the step S1200a.

All or some of the foregoing embodiments may be implemented by using software, hardware, firmware, or any combination thereof. When a software program is used to implement embodiments, embodiments may be implemented completely or partially in a form of a computer program product. The computer program product includes one or more computer instructions. When the computer program instructions are loaded and executed on the computer, the procedure or functions according to embodiments of this application are all or partially generated. The computer may be a general-purpose computer, a dedicated computer, a computer network, or other programmable apparatuses. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (digital subscriber line, DSL)) or wireless (for example, infrared, radio, or microwave) manner. The computer-readable storage medium may be any usable medium accessible by a computer, or a data storage device, such as a server or a data center, integrating one or more usable media. The usable medium may be a magnetic medium (for example, a floppy disk, a hard disk, or a magnetic tape), an optical medium (for example, a DVD), a semiconductor medium (for example, a solid state disk (solid state disk, SSD)), or the like. In embodiments of this application, the computer may include the apparatus described above.

Although this application is described with reference to embodiments, in a process of implementing this application that claims protection, a person skilled in the art may understand and implement another variation of disclosed embodiments by viewing accompanying drawings, disclosed content, and appended claims. In the claims, "comprising" (comprising) does not exclude another component or another step, and "a" or "one" does not exclude a case of multiple. A single processor or another unit may implement several functions enumerated in the claims. Some measures are recorded in dependent claims that are different from each other, but this does not mean that these measures cannot be combined to produce better effect.

Although this application is described with reference to specific features and embodiments thereof, it is clear that various modifications and combinations may be made to them without departing from the spirit and scope of this application. Correspondingly, the specification and accompanying drawings are merely example description of this application defined by the accompanying claims, and are considered as any of or all modifications, variations, combinations or equivalents that cover the scope of this application. It is clearly that a person skilled in the art can make various modifications and variations to this application without departing from the spirit and scope of this application. This application is intended to cover these modifications and variations of this application provided that they fall within the scope of protection defined by the following claims and their equivalent technologies.

## Claims

1. A phase compensation apparatus, wherein the phase compensation apparatus comprises a processing module and a first conversion module;
the processing module is configured to perform phase compensation on a first baseband signal based on a first digital ripple signal, to obtain a compensated first baseband signal, the first digital ripple signal is obtained based on a ripple signal of a first high voltage for a cathode, and the first high voltage for a cathode is used to supply power to a cathode of a first vacuum amplifier; and
the first conversion module is configured to convert the compensated first baseband signal into a first radio frequency signal.

2. The phase compensation apparatus according to claim 1, wherein the phase compensation apparatus further comprises a phase detector and a first analog-to-digital conversion module;
the processing module is further configured to determine a first phase compensation rule based on a first digital phase noise signal and a second digital ripple signal, and the first phase compensation rule is used for phase compensation for the first baseband signal;
the first digital phase noise signal is a signal obtained after a first output signal of the phase detector is output to the processing module by using the first analog-to-digital conversion module, a first input signal of the phase detector is an original input signal of the first vacuum amplifier, and a second input signal is an original output signal of the first vacuum amplifier; and
the second digital ripple signal is obtained based on a ripple signal of a second high voltage for a cathode, and the second high voltage for a cathode is used to supply power to the cathode of the first vacuum amplifier before the first high voltage for a cathode.

3. The phase compensation apparatus according to claim 2, wherein that the processing module is configured to perform phase compensation on a first baseband signal based on a first digital ripple signal, to obtain a compensated first baseband signal comprises:
the processing module is configured to determine a first phase compensation signal based on the first digital ripple signal and the first phase compensation rule; and
the processing module is further configured to perform phase compensation on the first baseband signal based on the first phase compensation signal, to obtain the compensated first baseband signal.

4. The phase compensation apparatus according to claim 3, wherein the first phase compensation rule is a first model;
that the processing module is further configured to determine a first phase compensation rule based on a first digital phase noise signal and a second digital ripple signal comprises:
the processing module is configured to establish the first model by using the second digital ripple signal as a model input and the first digital phase signal noise as a model output; and
that the processing module is configured to determine a first phase compensation signal based on the first digital ripple signal and the first phase compensation rule comprises:
the processing module is configured to input the first digital ripple signal into the first model, to obtain the first phase compensation signal.

5. The phase compensation apparatus according to any one of claims 2 to 4, wherein the phase compensation apparatus further comprises a second conversion module;
the processing module is further configured to perform phase compensation on a second baseband signal based on the first digital ripple signal, to obtain a compensated second baseband signal; and
the second conversion module is configured to convert the compensated second baseband signal into a second radio frequency signal.

6. The phase compensation apparatus according to claim 5, wherein the first high voltage for a cathode is further configured to supply power to a cathode of a second vacuum amplifier;
the first conversion module is further configured to output the first radio frequency signal to the first vacuum amplifier; and
the second conversion module is further configured to output the second radio frequency signal to the second vacuum amplifier; or
the first vacuum amplifier comprises a first input energy transmission window and a second input energy transmission window;
the first conversion module is further configured to output the first radio frequency signal to the first input energy transmission window; and
the second conversion module is further configured to output the second radio frequency signal to the second input energy transmission window.

7. The phase compensation apparatus according to claim 5 or 6, wherein
the processing module is further configured to determine a second phase compensation rule based on a second digital phase noise signal and the second digital ripple signal, and the second phase compensation rule is used for phase compensation for the second baseband signal;
the second digital phase noise signal is a signal obtained after a second output signal of the phase detector is output to the processing module by using the first analog-to-digital conversion module; and
when the first high voltage for a cathode is further used to supply the power to the cathode of the second vacuum amplifier, the second high voltage for a cathode is further used to supply power to the cathode of the second vacuum amplifier before the first high voltage for a cathode, a third input signal of the phase detector is an original input signal of the second vacuum amplifier, and a fourth input signal is an original output signal of the second vacuum amplifier; or
when the first vacuum amplifier comprises the second input energy transmission window, a third input signal of the phase detector is an original input signal of the second input energy transmission window of the first vacuum amplifier, and a fourth input signal is an original output signal of a second output energy transmission window corresponding to the second input energy transmission window.

8. The phase compensation apparatus according to claim 7, wherein that the processing module is configured to perform phase compensation on a second baseband signal based on the first digital ripple signal, to obtain a compensated second baseband signal comprises:
the processing module is configured to determine a second phase compensation signal based on the first digital ripple signal and the second phase compensation rule; and
the processing module is further configured to perform phase compensation on the second baseband signal based on the second phase compensation signal, to obtain the compensated second baseband signal.

9. The phase compensation apparatus according to claim 8, wherein the second phase compensation rule is a second model;
that the processing module is further configured to determine a second phase compensation rule based on a second digital phase noise signal and the second digital ripple signal comprises:
the processing module is configured to establish the second model by using the second digital ripple signal as a model input and the second digital phase signal noise as a model output; and
that the processing module is configured to determine a second phase compensation signal based on the first digital ripple signal and the second phase compensation rule comprises:
the processing module is configured to input the first digital ripple signal into the second model, to obtain the second phase compensation signal.

10. The phase compensation apparatus according to any one of claims 2 to 9, wherein the phase detector comprises a frequency mixer, a 90-degree phase shifter, and a low-pass filter.

11. The phase compensation apparatus according to any one of claims 1 to 10, wherein the phase compensation apparatus further comprises a ripple signal preprocessing module and a second analog-to-digital conversion module;
the ripple signal preprocessing module is configured to perform preprocessing on the ripple signal of the first high voltage for a cathode, to obtain a first analog ripple signal, and the preprocessing is used to adapt to an operating range of the second analog-to-digital conversion module; and
the second analog-to-digital conversion module is configured to perform analog-to-digital conversion on the first analog ripple signal, to obtain the first digital ripple signal.

12. The phase compensation apparatus according to any one of claims 1 to 11, wherein the first high voltage for a cathode is supplied by a first power module, and the first power module is a low-voltage to high-voltage power module.

13. A phase compensation method, wherein the method comprises:
performing phase compensation on a first baseband signal based on a first digital ripple signal, to obtain a compensated first baseband signal, wherein the first digital ripple signal is obtained based on a ripple signal of a first high voltage for a cathode, and the first high voltage for a cathode is used to supply power to a cathode of a first vacuum amplifier; and
converting the compensated first baseband signal into a first radio frequency signal.

14. The method according to claim 13, wherein the method further comprises:
determining a first phase compensation rule based on a first digital phase noise signal and a second digital ripple signal, wherein the first phase compensation rule is used for phase compensation for the first baseband signal, wherein
the first digital phase noise signal is obtained based on a first output signal of a phase detector, a first input signal of the phase detector is an original input signal of the first vacuum amplifier, and a second input signal is an original output signal of the first vacuum amplifier; and
the second digital ripple signal is obtained based on a ripple signal of a second high voltage for a cathode, and the second high voltage for a cathode is used to supply power to the cathode of the first vacuum amplifier before the first high voltage for a cathode.

15. The method according to claim 14, wherein the performing phase compensation on a first baseband signal based on a first digital ripple signal, to obtain a compensated first baseband signal comprises:
determining a first phase compensation signal based on the first digital ripple signal and the first phase compensation rule; and
performing phase compensation on the first baseband signal based on the first phase compensation signal, to obtain the compensated first baseband signal.

16. The method according to claim 15, wherein the first phase compensation rule is a first model; the determining a first phase compensation rule based on a first digital phase noise signal and a second digital ripple signal comprises:
establishing the first model by using the second digital ripple signal as a model input and the first digital phase signal noise as a model output; and
the determining a first phase compensation signal based on the first digital ripple signal and the first phase compensation rule comprises:
inputting the first digital ripple signal into the first model, to obtain the first phase compensation signal.

17. The method according to any one of claims 14 to 16, wherein the method further comprises:
performing phase compensation on a second baseband signal based on the first digital ripple signal, to obtain a compensated second baseband signal; and
converting the compensated second baseband signal into a second radio frequency signal.

18. The method according to claim 17, wherein
when the first high voltage for a cathode is further used to supply power to a cathode of a second vacuum amplifier, the method further comprises:
outputting the first radio frequency signal to the first vacuum amplifier, and outputting the second radio frequency signal to the second vacuum amplifier; or
when the first vacuum amplifier comprises a first input energy transmission window and a second input energy transmission window, the method further comprises:
outputting the first radio frequency signal to the first input energy transmission window of the first vacuum amplifier, and outputting the second radio frequency signal to the second input energy transmission window of the first vacuum amplifier.

19. The method according to claim 17 or 18, wherein the method further comprises:
determining a second phase compensation rule based on a second digital phase noise signal and the second digital ripple signal, wherein the second phase compensation rule is used for phase compensation for the second baseband signal;
the second digital phase noise signal is obtained based on a second output signal of the phase detector; and
when the first high voltage for a cathode is further used to supply the power to the cathode of the second vacuum amplifier, the second high voltage for a cathode is further used to supply power to the cathode of the second vacuum amplifier before the first high voltage for a cathode, a third input signal of the phase detector is an original input signal of the second vacuum amplifier, and a fourth input signal is an original output signal of the second vacuum amplifier; or
when the first vacuum amplifier comprises the second input energy transmission window, a third input signal of the phase detector is an original input signal of the second input energy transmission window of the first vacuum amplifier, and a fourth input signal is an original output signal of a second output energy transmission window corresponding to the second input energy transmission window.

20. The method according to claim 19, wherein the performing phase compensation on a second baseband signal based on the first digital ripple signal, to obtain a compensated second baseband signal comprises:
determining a second phase compensation signal based on the first digital ripple signal and the second phase compensation rule; and
performing phase compensation on the second baseband signal based on the second phase compensation signal, to obtain the compensated second baseband signal.

21. The method according to claim 20, wherein the second phase compensation rule is a second model; the determining a second phase compensation rule based on a second digital phase noise signal and the second digital ripple signal comprises:
establishing the second model by using the second digital ripple signal as a model input and the second digital phase signal noise as a model output; and
the determining a second phase compensation signal based on the first digital ripple signal and the second phase compensation rule comprises:
inputting the first digital ripple signal into the second model, to obtain the second phase compensation signal.

22. The method according to any one of claims 13 to 21, wherein that the first digital ripple signal is obtained based on a ripple signal of a first high voltage for a cathode comprises:
the first digital ripple signal is a digital ripple signal obtained after analog-to-digital conversion is performed on a first analog ripple signal, the first analog ripple signal is obtained after preprocessing is performed on the ripple signal of the first high voltage for a cathode, and the preprocessing is used to adapt to an operating range of an analog-to-digital conversion module.
